# EUROPÄISCHE PATENTSCHRIFT

(11) **EP 0 509 075 B1**
(45) Veröffentlichungstag und Bekanntmachung des Hinweises auf die Patenterteilung: **18.09.1996**
(21) Anmeldenummer: 91918558.7
(22) Anmeldetag: 26.10.1991
(51) Int. Cl.: H03K 17/16, B60R 16/02

(54) **SCHALTANORDNUNG IN KRAFTFAHRZEUGEN ZUM GETAKTETEN EINSCHALTEN VON INDUKTIVEN VERBRAUCHERN**
CIRCUIT FOR USE IN MOTOR VEHICLES FOR THE TIMED SWITCHING OF INDUCTIVE CONSUMERS
CIRCUIT DANS DES VEHICULES AUTOMOBILES POUR LA MISE EN CIRCUIT A CYCLE FIXE DE CONSOMMATEURS INDUCTIFS

(30) Priorität: 02.11.1990 DE 4034845
(43) Veröffentlichungstag der Anmeldung: 21.10.1992
(73) Patentinhaber: Bayerische Motoren Werke Aktiengesellschaft, 80788 München (DE)
(72) Erfinder: GAUBATZ, Karl-Heinz, D-8011 Parsdorf (DE)
(86) Internationale Anmeldenummer: EP9102025
(87) Internationale Veröffentlichungsnummer: WO9208284

(56) Entgegenhaltungen:
- US-A- 4 504 779
- US-A- 4 746 813
- ELEKTRONIK. Bd. 37, Nr. 11, 27. Mai 1988, MUNCHEN DE Seiten 74 - 80; LORENZ , AMANN: 'MOS-MODULE :EFFEKTIVE LEISTUNG -HALBLEITERSCHALTER BEI HOHEN
- TAKTFREQUENZEN' siehe Seite 77, Spalte 2, Zeile 11 - Seite 80, Spalte 2, Zeile 27; Abbildungen 7,9,10-12
- ELECTRONIC ENGINEERING. Bd. 56, Nr. 695, November 1984, LONDON GB Seiten 51 - 57; SEVERNS: 'AVOIDING SPURIOUS MOSFET TURN-ON' siehe das ganze Dokument
- Dieter Nührmann,"Operationsverstärker, Motorsteuerungen, HF- und Me gerätetechnik", FranzisVerlag München, 1985, Seiten 229-231, 243 und 244
- Dieter Nührmann, "Stromversorgungsschaltungen, Triac- und Zündschaltungen";FranzisVerlag München, 1984, Seiten 189, 190

## Beschreibung

Die Erfindung bezieht sich auf eine Schaltanordnung nach dem Oberbegriff des Patentanspruchs 1.

Eine derartige Schaltanordnung ist beispielsweise aus der DE-38 35 662 A1, aus dem Artikel "Neue Fast-Recovery Leistungs-Mosfet verbessern den Wirkungsgrad bei Hochspannungs-Motoransteuerungen" in der Zeitschrift "Der Elektroniker", Nr. 5/1990, und aus dem Artikel "MOSFETs control motors in automotive applications" in der Zeitschrift "Electronic Components and Applicatlons", Vol. 9 No. 2, bekannt. Derartige Schaltanordnungen werden zur Minimierung der Verlustleistung oder für hochfrequente Taktung eingesetzt. Beispielsweise ist aus dem Lehrbuch "Stromversorgungsschaltungen, Triac- und Zündschaltungen" von D. Nührmann, 1984, S. 189, allgemein eine Schaltanordnung zum getakteten Einschalten von induktiven Verbrauchern mittels eines Halbleiterleistungsschalters bekannt, bei der die Anstiegszeit durch Erhöhung des Innenwiderstandes der Ansteuerquelle verlängert wird. Durch diese bekannte Schaltanordnung entstehen jedoch bauteilbedingte Störschwingungen beim Durchschalten des Halbleiterleistungsschalters, die sich auf die Anstiegsflanke des Einschaltsignals (Drainspannung) des induktiven Verbrauchers auswirken.

Bei einer Ansteuerung induktiver Verbraucher in Kraftfahrzeugen, z.B. von Elektromotoren, wird häufig mit hohen Strömen getaktet. Dabei tritt bei ungenügenden Entstörmaßnahmen elektromagnetische Abstrahlung auf, wobei elektronische Komponenten erheblich gestört werden können. Diese Abstrahlung wird einerseits durch Störschwingungen beim Durchschalten des Halbleiterleistungsschalters, andererseits von hochfrequenten Anteilen der steilen Flanken der Taktsignale verursacht.

Der Erfindung liegt die Aufgabe zugrunde, eine Schaltanordnung der eingangs genannten Art zu schaffen, mit der induktive Verbraucher mit hohen Strömen getaktet und frei von elektromagnetischer Abstrahlung ansteuerbar sind.

Dies wird durch eine Schaltanordnung mit den kennzeichnenden Merkmalen des Patentanspruchs 1 erreicht. Jedes der darin geforderten zwei Zeitverhältnisse wirkt in erster Linie je einer der beiden oben genannten Ursachen für elektromagnetische Abstrahlung, wie im folgenden beschrieben, entgegen.

Das eine Problem, die bauteilbedingten Störschwingungen beim Durchschalten des Halbleiterleistungsschalters, wird gelöst, wenn die Ansteuerquelle derart ausgestaltet ist, daß sie eine Reaktionszeit auf die Störschwingungen aufweist, durch die eine Kompensation dieser Störschwingungen erreicht wird. Dabei wird unter der Eigenzeit des Halbleiterleistungsschalters die Periodendauer einer der Störschwingungen verstanden, die sich zum Durchschaltaugenblick des Halbleiterleistungsschalters aus den Umladevorgängen in den parasitären Kapazitäten des Halbleiterleistungsschalters im Zusammenwirken mit dem Innenwiderstand der Ansteuerquelle ergeben. Je kleiner der Innenwiderstand der Ansteuerquelle ist, desto geringer wird die Eigenzeit des Halbleiterleistungsschalters. Die Reaktionszeit der Ansteuerquelle ist die kürzeste Zeit, innerhalb derer die Ansteuerquelle die entstehenden Störschwingungen kompensieren kann, so daß eine linear ansteigende Spannung am Ausgang der Ansteuerquelle, die mit der Steuerspannung des Halbleiterleistungsschalters identisch ist, erreicht wird.

Das zweite Problem, die elektromagnetische Abstrahlung durch hochfrequente Anteile eines Taktsignals mit steilen Flanken, wird gelöst, wenn die Flanken durch eine Erhöhung der Anstiegszeit soweit abgeflacht werden, bis die Abstrahlung entsprechend der Vorschriften für Kraftfahrzeuge minimiert ist. Hierbei ist die Anstiegszeit die Zeit, Innerhalb derer die Ansteuerquelle die Steuerspannung des Halbleiterleistungsschalters gleichmäßig vom Minimal- auf den Maximalpegel erhöht. Die Anstiegszeit ist ein Vielfaches der Reaktionszeit der Ansteuerquelle.

Demnach wird durch die erfindungsgemäßen Zeitverhältnisse elektromagnetische Abstrahlung schon an ihrer Entstehung gehindert, sodaß keine kostenintensiven Entstörmaßnahmen zu ihrer Unterdrückung getroffen werden müssen.

Eine schaltungstechnisch besonders vorteilhafte Ausführung der Erfindung ist Gegenstand des Patentanspruchs 2.

Die Verwendung eines Feldeffekttransistors als Halbleiterleistungsschalters begünstigt die Verkürzung der Eigenzeit dadurch, daß Feldeffekttransistoren keine Speicherzeit besitzen und schneller geschaltet werden können als beispielsweise Bipolartransistoren. Mit dem Einsatz eines Leistungsoperationsverstärkers in der Ansteuerquelle erreicht man auf einfache Weise eine sehr kurze Reaktionszeit. Gleichzeitig sorgt die minimale Niederohmigkeit des Innenwiderstandes eines Leistungsoperationsverstärkers für die Einstellung des erfindungsgemäßen Verhältnisses der Eigenzeit zur Reaktionszeit.

In den Zeichnungen ist ein Ausführungsbeispiel der Erfindung dargestellt. Es zeigt
- Fig. 1: eine Schaltanordnung zum getakteten Schalteneines induktiven Verbrauchers und
- Fig. 2: den zeitlichen Verlauf der Steuerspannung des Feldeffekttransistors bei Verwendung der erfindungsgemäßen Schaltanordnung.

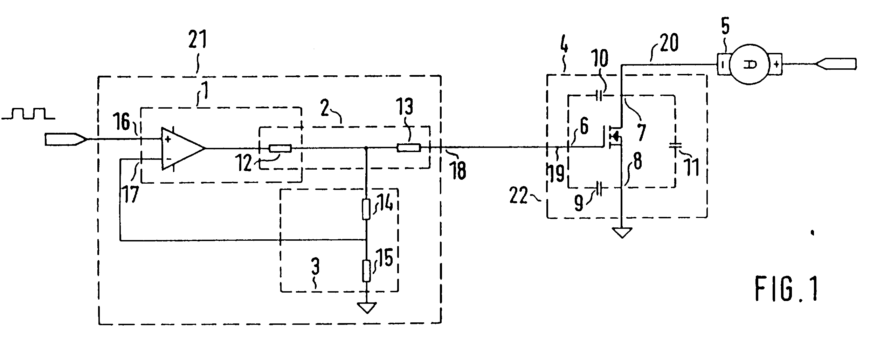

In Fig. 1 ist eine zu taktende Induktivität 5, z.B. ein Elektromotor für ein Heizgebläse, am Drainkontakt 7 des Feldeffekttransistors 4 angeschlossen. Der Feldeffekttransistor 4 ist ein selbstsperrender n-Kanal, Metall-Oxid-Halbleiter-Feldeffekttransistor. Zwischen Gate 6 und Drain 7, Gate 6 und Source 8, sowie Source 8 und Drain 7 liegen die parasitären Kapazitäten 10, 9 und 11 des Feldeffekttransistors 4. Die Kapazitäten 10.9 und 11 bilden gemeinsam die Gesamtkapazität 22 des Feldeffekttransistors 4.

Zischen Gate 6 und Source 8 liegt die Steuerspannung 19 des Feldeffekttransistors 4 an. Die Steuerspannung 19 ist gleichzeitig die Ausgangsspannung 18 der Ansteuerquelle 21. Die Ansteuerquelle 21 besteht aus einem Leistungsoperationsverstärker 1 mit seinem Innenwiderstand 12, aus dem dazu in Serie geschalteten Vorwiderstand 13, der mit dem Gate 6 des Feldeffekttransistors 4 verbunden ist und aus einem Spannungsteiler 3. Der Spannungsteiler 3 wird aus den beiden Widerständen 14 und 15 gebildet und ist dem Vorwiderstand 13 und dem Innenwiderstand 12 des Leistungsoperationsverstärkers 1 verbunden. Ein Teil der Ausgangsspannung 18 des Leistungsoperationsverstärkers 1 wird über den Spannungsteiler 3 zwischen den Widerständen 14 und 15 an den negativen Eingang 17 des Leistungsoperationsverstärkers 1 zurückgeführt.

Zur Ansteuerung der Induktivität 5 wird ein Taktsignal, z.B. mit einer Frequenz von 20 kHz, am positiven Eingang 16 des Leistungsoperationsverstärkers 1 angelegt.

Die Ansteuerquelle 21 verstärkt den Pegel dieses Taktsignals, z.B. von 1V auf 10V, und schaltet damit den Feldeffekttransistor 4. Der Drainstrom 20 des Feldeffekttransistors 4 wiederum aktiviert die Induktivität 5 mit der vom Taktsignal vorgegebenen Frequenz.

Elektromagnetische Abstrahlung entsteht zum einen bei Störschwankungen des Drainstroms 20, der Stromwerte um 30 A annehmen kann.

Diese Störschwankungen des Drainstroms 20 hängen direkt von Störschwingungen der Steuerspannung 19 des Feldeffekttransistors 4 an der Durchschaltschwelle ab.

Die Störschwingungen der Steuerspannung 19 wiederum resultieren aus den Umladevorgängen In den parasitären Kapazitäten 9, 10 und 11 des Feldeffekttransistors 4 in Verbindung mit dem Gesamtinnenwiderstand 2 der Ansteuerquelle 21, der sich aus der Reihenschaltung des Innenwiderstandes 12 und des Vorderwiderstandes 13 ergibt.

Die Zeitkonstante ergibt sich aus der Multiplikation der Gesamtkapazität 22 der parasitäten Kapazitäten 9, 10 und 11 mit dem Gesamtinnenwiderstand 2 der Ansteuerquelle 21. Die Zeitkonstante wird umso kleiner, je niederohmiger der Gesamtinnenwiderstand 2 ist.

Die Reaktionszeit der Ansteuerquelle wird durch die Wahl des Leistungsoperationsverstärkers 1 festgelegt. Der Ausgang des Leistungsoperationsverstärkers 1 ist über den Spannungsteiler 3 im Sinne einer Gegenkopplung zum invertierten Eingang rückgekoppelt. Durch diese Gegenkopplung wirkt, wie beispielsweise aus dem Lehrbuch "Halbleiter-Schaltungstechnik" (insbesondere S. 129 und S. 350),Tietze/Schenk, 1986, hervorgeht, die Ansteuerquelle 21 als spannungsgeregelte Spannungsquelle. Somit ergibt sich die Reaktionszeit der Ansteuerquelle 21 als Regelzeit, innerhalb derer die Störschwingungen kompensiert bzw. ausgeregelt werden..

An einem Zahlenbeispiel kann die Erfindung rechnerisch nachvollzogen werden:

Es wird ein Feldeffekttransistor 4 mit einer Gesamtkapazität 22 von 1500pF verwendet.

Der Gesamtwiderstand 2 der Ansteuerquelle 21 setzt sich aus dem vorgegebenen Innenwiderstand 12 des Leistungsoperationsverstärkers 1 mit 17 Ohm und dem mit 33 Ohm dimensionierten Vorwiderstand 13 zu 50 Ohm zusammen.

Damit ergibt sich eine Zeitkonstante von 1500pF * 50 Ohm = 75 ns.
Die Periodendauer einer Störschwingung ist ca. 5 * 75 ns = 375 ns.

Zum anderen entsteht elektromagnetische Abstrahlung wie eingangs erwähnt auch durch hochfrequente Anteile eines Taktsignals.

Hierzu verstärkt der Leistungsoperationsverstärker 1 den Eingangspegel mit einem Faktor 10, hier also von 1V auf 10V, und bewirkt durch seine Slewrate von 1V/1µs eine Anstiegszeit der Steuerspannung 19 auf den Maximalwert von 10µs. Der Leistungsoperationsverstärker 1 verhindert mit dieser Dimensionierung elektromagnetische Abstrahlung durch das Verhältnis der Anstiegszeit, 10 µs, zur Periodendauer des Taktsignals, 1/20kHz = 50µs, von ca. 1:5 besonders wirkungsvoll.

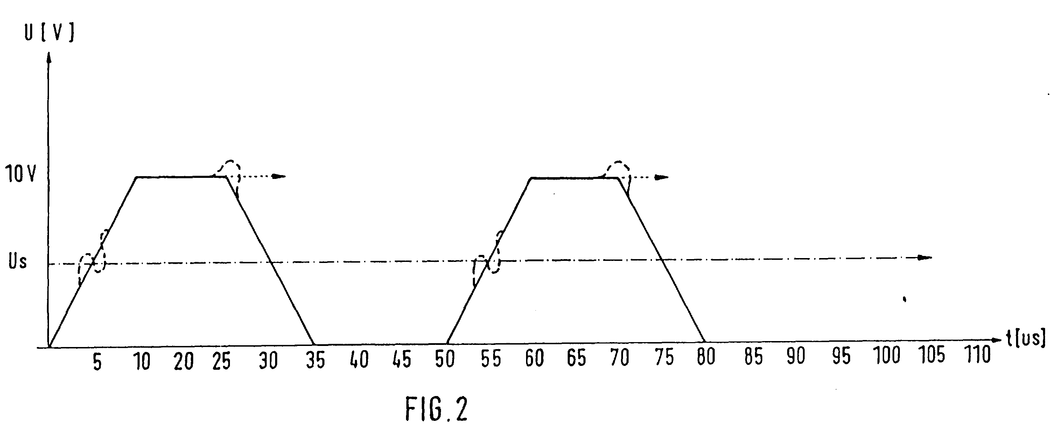

In Fig. 2 wird der zeitliche Verlauf der durch die erfindungsgemäße Schaltanordnung erzeugten Steuerspannung 19 des Feldeffekttransistors 4 mit den Werten des Zahlenbeispiels dargestellt. Das Taktsignal zeigt einen flachen und glatten Anstieg der Steuerspannung 19. Ohne die erfindungsgemäße Schaltanordnung würden die in Fig. 2 gestrichelt gezeichneten Störschwingungen in der steigenden Flanke an der Durchschaltschwelle auftreten. Möglich sind bei der Verwendung eines Feldeffekttransistors auch Überschwinger beim Abschalten der Steuerspannung, wie an der fallenden Flanke gestrichelt angedeutet ist. Diese Störung kann jedoch durch eine externe Beschaltung, z.B. durch einen Hochpaß, unterdrückt werden, was jedoch nicht Gegenstand der Erfindung ist.

## Patentansprüche

1. Schaltanordnung in Kraftfahrzeugen zum getakteten Einschalten von induktiven Verbrauchern mittels eines durch eine Ansteuerquelle getakteten Halbleiterleistungsschalters, dadurch gekennzeichnet, daß die Ansteuerquelle (21) derart ausgestaltet ist, daß sie eine Reaktionszeit auf beim Durchschalten des Halbleiterleistungsschalters (4) entstehende bauteilbedingte Störschwingungen aufweist, durch die eine Kompensation dieser Störschwingungen erreicht wird, wobei die Anstiegszeit der Steuerspannung des Halbleiterleistungsschalters (4) ein Vielfaches der Reaktionszeit ist.

2. Schaltanordnung nach Patentanspruch 1, dadurch gekennzeichnet, daß die Ansteuerquelle (21) einen niederohmigen Gesamtinnenwiderstand (2) und eine Gegenkopplung aufweist.

3. Schaltanordnung nach Patentanspruch 1 oder 2, dadurch gekennzeichnet, daß die Anstiegszeit (10 µs) der Steuerspannung (19; 10 V) des Halbleiterleistungsschalters (4) durch die Slewrate (1V/µs) der Ansteuerquelle (21; 1) vorgegeben wird.

## Claims

1. A circuit arrangement in a motor vehicle for the clocked switching of inductive appliances by means of a semiconductor power switch clocked by a control source, **characterised in that** the control source (21) is designed such that it has a reaction time to component-related spurious oscillations arising upon switching of the semiconductor power switch (4) which enables these spurious oscillations to be compensated for, whereby the rise time of the control voltage of the semiconductor power switch (4) is a multiple of the reaction time.

2. A circuit arrangement according to claim 1, **characterised in that** the control source (21) has a low-ohm total internal resistance (2) and a negative feedback.

3. A circuit arrangement according to claim 1 or 2, **characterised in that** the rise time (10 µs) of the control voltage (19; 10 V) of the semiconductor power switch (4) is determined by the slew rate (1 V/µs) of the control source (21; 1).

## Revendications

1. Circuit utilisé dans des véhicules à moteur pour mettre en circuit à cycle fixe des consommateurs inductifs au moyen d'un commutateur de puissance à semi-conducteurs synchronisé par une source d'amorçage,
circuit caractérisé en ce que
la source d'amorçage (21) est constituée de telle façon qu'elle présente un temps de réaction aux oscillations parasites dues aux composants lors de l'enclenchement du commutateur de puissance à semi-conducteurs (4), grâce auquel on obtienne une compensation de ces oscillations parasites, le temps de montée de la tension de commande du commutateur de puissance à semi-conducteurs (4) étant un multiple du temps de réaction.

2. Circuit selon la revendication 1,
caractérisé en ce que
la source d'amorçage (21) présente une résistance interne globale de basse impédance (2) et un rétro-couplage.

3. Circuit selon la revendication 1 ou 3
caractérisé en ce que
le temps de montée (10µs) de la tension de commande (19 ; 10V) du commutateur de puissance à semi-conducteurs (4), est prédéfini par le taux de saut (1 V/µS) de la source d'amorçage (21 ; 1).
